# EUROPÄISCHE PATENTSCHRIFT

(11) **EP 2 681 834 B1**
(45) Veröffentlichungstag und Bekanntmachung des Hinweises auf die Patenterteilung: **26.08.2015**
(21) Anmeldenummer: 12714597.7
(22) Anmeldetag: 19.03.2012
(51) Int. Cl.: H02M 7/00, H05K 7/14, H02M 7/483

(54) **MODULARES STROMRICHTERSCHRANKSYSTEM**
MODULAR CONVERTER CABINET SYSTEM
SYSTÈME D'ARMOIRE DE CONVERTISSEUR DE PUISSANCE MODULAIRE

(30) Priorität: 07.04.2011 DE 102011006987
(43) Veröffentlichungstag der Anmeldung: 08.01.2014
(73) Patentinhaber: Siemens Aktiengesellschaft, 80333 München (DE)
(72) Erfinder: HILLER, Marc, 91207 Lauf an der Pegnitz (DE); PFAUSER, Anton, 96178 Pommersfelden (DE)
(86) Internationale Anmeldenummer: PCT/EP2012/054766
(87) Internationale Veröffentlichungsnummer: WO 2012/136465

(56) Entgegenhaltungen:
- EP-A1- 1 113 570
- WO-A2-2011/008514
- US-A1- 2007 048 561

## Beschreibung

Die Erfindung bezieht sich auf ein modulares Stromrichterschranksystem eines Stromrichters mit wenigstens einem ein oberes und ein unteres Stromrichterventil aufweisenden Phasenmodul, wobei jedes Stromrichterventil wenigstens zwei Stromrichterzellen und eine Zweigdrossel aufweist, die elektrisch in Reihe geschaltet sind.

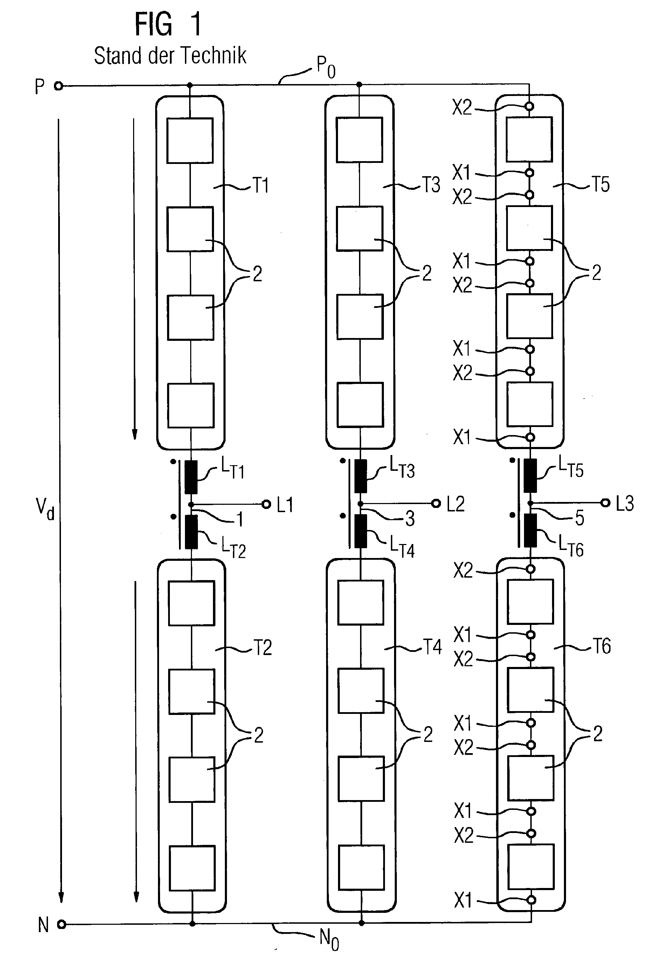

Ein derartiger Stromrichter, der auch als Modular-Multilevel-Converter (M2LC) bezeichnet wird, ist aus der DE 101 03 031 A1 bekannt. Ein Ersatzschaltbild eines derartigen dreiphasigen Stromrichters ist in der FIG 1 näher dargestellt.

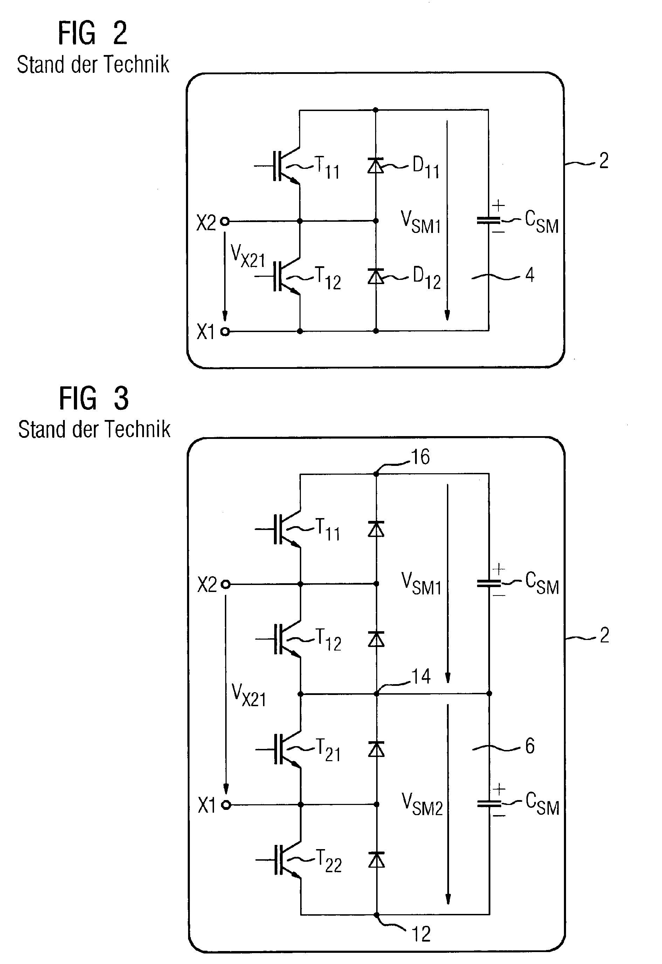

Gemäß diesem Ersatzschaltbild weist dieser Stromrichter drei Phasenmodule 1, 3 und 5 auf, die jeweils ein oberes und ein unteres Stromrichterventil T1, T2 bzw. T3, T4 bzw. T5, T6 und jeweils eine Zweigdrossel L_{T1}, L_{T2} bzw. L_{T3}, L_{T4} bzw. L_{T5}, L_{T6} aufweisen. Jedes Stromrichterventil T1,...,T6 dieser Phasenmodule 1, 3 und 5 weist wenigstens zwei Stromrichterzellen 2 auf, die elektrisch in Reihe geschaltet sind. Im dargestellten Ersatzschaltbild weist jedes Stromrichterventil T1,...,T6 vier solcher Stromrichterzellen 2 auf. Das Ersatzschaltbild einer Stromrichterzelle 2 des M2LC ist in FIG 2 näher dargestellt. Jede Zweigdrossel L_{T1},..., L_{T6} ist mit der Reihenschaltung mehrerer Stromrichterzellen 2 eines Stromrichterventils T1,...,T6 elektrisch in Reihe geschaltet. Mittels dieser Stromrichterzellen 2 der Stromrichterventile T1,T2 bzw. T3,T4 bzw. T5,T6 eines jeden Phasenmoduls 1 bzw. 3 bzw. 5 des M2LC wird an jedem Ausgang L1 bzw. L2 bzw. L3 eines jeden Phasenmoduls 1 bzw. 3 bzw. 5 eine stufenförmige Ausgangsspannung generiert. Je mehr Stromrichterzellen 2 pro Stromrichterventil T1,...,T6 verwendet werden, um so feinstufiger ist die Ausgangsspannung am Ausgang L1 bzw.L2 bzw. L3. Je feinstufiger diese Ausgangsspannungen sind, umso geringer ist der Aufwand für ein Ausgangsfilter.

Der Aufbau einer Stromrichterzelle 2, dessen Ersatzschaltbild in der FIG 2 näher dargestellt ist, ist ebenfalls aus der DE 10 103 031 A1 bekannt. Als Stromrichterzelle 2 ist ein so genanntes zweipoliges Subsystem 4 vorgesehen, das zwei abschaltbare Halbleiter T₁₁ und T₁₂, zwei Dioden D₁₁ und D₁₂ und einen Speicherkondensator C_{SM} aufweist. Die beiden abschaltbaren Halbleiter T₁₁ und T₁₂, insbesondere Insulated Gate Bipolar Transistors (IGBTs), sind elektrisch in Reihe geschaltet. Diese Reihenschaltung ist der Speicherkondensator C_{SM} elektrisch parallel geschaltet. Jede Diode D₁₁ bzw. D₁₂ ist einem abschaltbaren Halbleiter T₁₁ bzw. T₁₂ elektrisch antiparallel geschaltet. Dadurch werden diese Dioden D₁₁ und D₁₂ auch als Freilaufdioden bezeichnet. Ein Anschluss X2 der Stromrichterzelle 2 wird vom Verbindungspunkt der beiden abschaltbaren Halbleiter T₁₁ und T₁₂ des zweipoligen Subsystems 2 gebildet, wogegen ein weiterer Anschluss X1 der Stromrichterzelle 2 vom negativen Pol des Speicherkondensators C_{SM}, der mit einem Anoden-Anschluss der Diode D₁₂ und einem Emitter-Anschluss des abschaltbaren Halbleiters T₁₂ elektrisch leitend verbunden ist, gebildet wird. An diesen Anschlüssen X2 und X1 der Stromrichterzelle 2 steht eine Zellenspannung V_{X21} an. Am Speicherkondensator C_{SM}, insbesondere einem Elektrolytkondensator, steht eine Kondensatorspannung V_{SM} an. Die Amplitude der Zellenspannung V_{X21} kann abhängig vom Schaltzustand der beiden abschaltbaren Halbleiter T₁₁ und T₁₂ gleich der Amplitude der Kondensatorspannung V_{SM} sein oder 0V betragen. Weitere Einzelheiten des Stromrichters gemäß FIG 1 und der Stromrichterzelle 2 gemäß FIG 2 sind der DE 10 103 031 A1 zu entnehmen.

In FIG 3 ist ein Ersatzschaltbild eines so genannten Doppel-Submoduls 6 dargestellt, das ebenfalls als Stromrichterzelle 2 verwendet werden kann. Ein derartiges Doppel-Submodul 6 ist aus der DE 10 2005 041 087 A1 bekannt. Dieses Doppel-Submodul 6 weist gemäß dem Ersatzschaltbild vier abschaltbare Halbleiter T₁₁, T₁₂, T₂₁ und T₂₂, insbesondere IGBTs, vier Dioden D₁₁, D₁₂, D₂₁ und D₂₂, und zwei Speicherkondensatoren C_{SM} auf. Eine in der DE 10 2005 041 087 A1 gezeigte Elektronikbaugruppe des Doppel-Submoduls 6 ist hier nicht explizit dargestellt. Diese vier abschaltbaren Halbleiter T₁₁, T₁₂, T₂₁ und T₂₂ sind elektrisch in Reihe geschaltet. Jedem dieser abschaltbaren Halbleiter T₁₁, T₁₂, T₂₁ und T₂₂ ist eine Diode D₁₁, D₁₂, D₂₁ und D₂₂ elektrisch antiparallel geschaltet. Jeweils ein Speicherkondensator C_{SM} ist elektrisch parallel zu jeweils zwei elektrisch in Reihe geschaltete abschaltbare Halbleiter T₁₁, T₁₂ bzw. T₂₁, T₂₂ geschaltet. Diese beiden Speicherkondensatoren C_{SM}, insbesondere Elektrolytkondensatoren, sind außerdem elektrisch in Reihe geschaltet. Der Anschluss X2 der Stromrichterzelle 2 wird vom Verbindungspunkt der beiden abschaltbaren Halbleiter T₁₁ und T₁₂ und der Anschluss X1 der Stromrichterzelle 2 durch den Verbindungspunkt der beiden abschaltbaren Halbleiter T₂₁ und T₂₂ gebildet. An diesen Anschlüssen X2 und X1 steht eine Zellenspannung V_{X21} an, die gegenüber der Ausführungsform der Stromrichterzelle 2 gemäß FIG 2 vier Potentialstufen aufweist. Weitere Einzelheiten dieses Doppel-Submoduls 6 sind der DE 102005041087 A1 zu entnehmen.

Da der in der FIG 1 dargestellte Stromrichter eine Vielzahl von Stromrichterzelle 2 gemäß der Figuren 2 und 3 aufweist, gehört dieser Stromrichter zu den so genannten Zellen-Stromrichtern. Zu diesen Zellen-Stromrichtern gehört auch der Zellen-Stromrichter "ROBICON Perfect Harmony" der Fa. Siemens, der in der Siemens-Broschüre mit dem Titel "Der Umrichter für höchste Anforderungen" mit der Bestell-Nr. E20001-A10-P590 und dem Druckdatum 03/2008, näher beschrieben ist. Dieser bekannte Zellenstromrichter weist als Stromrichterzelle einen Spannungszwischenkreis-Umrichter auf, der aus einer dreiphasigen Wechselspannung eine einphasige Wechselspannung generiert. Dazu weist jeder Spannungszwischenkreis-Umrichter einspeiseseitig eine sechspulsige Diodenbrücke und lastseitig eine vierpulsige IGBT-Brücke auf. Beide Brückenschaltungen sind gleichspannungsseitig mittels eines Zwischenkreiskondensators miteinander elektrisch leitend verbunden. Jede Phase dieses Zellenstromrichters weist vier Stromrichterzellen auf, die lastseitig elektrisch in Reihe geschaltet sind. Jede Stromrichterzelle ist speiseseitig mit einem dreiphasigen Sekundärwicklungssystem eines netzseitigen Stromrichter-Transformators verknüpft. Das heißt, der in der genannten Siemens-Broschüre vorgestellte Zellenstromrichter weist einen Stromrichter-Transformator mit zwölf dreiphasigen Sekundärwicklungssystemen auf. Werden pro Phase des Zellenstromrichters sechs Stromrichterzellen verwendet, wird bereits ein Stromrichter-Transformator mit achtzehn dreiphasigen Sekundärwicklungssystemen benötigt. Die drei Phasen dieses Zellenstromrichters sind in Stern geschaltet, an deren freien Enden (Phasenanschlüsse) eine Last, beispielsweise ein Drehstrommotor, angeschlossen werden kann. Auf der Seite 10 dieser Broschüre ist im linken Bild in der Mitte ein Ventilschrank mit 12 Stromrichterzellen dargestellt, wobei Stromrichterzellen einer Phase in einer Ventiletage des Ventilschranks nebeneinander angeordnet sind. Da dieser Zellenstromrichter drei Phasen aufweist, sind im Ventilschrank drei Ventiletagen vorgesehen, die übereinander beabstandet angeordnet sind. Jede Ventiletage nimmt die Stromrichterzellen einer Phase auf, wobei diese innerhalb einer Ventiletage nebeneinander angeordnet sind. In diesem Bild ist auch ein Drosselschrank erkennbar, in dem der Stromrichter-Transformator untergebracht ist.

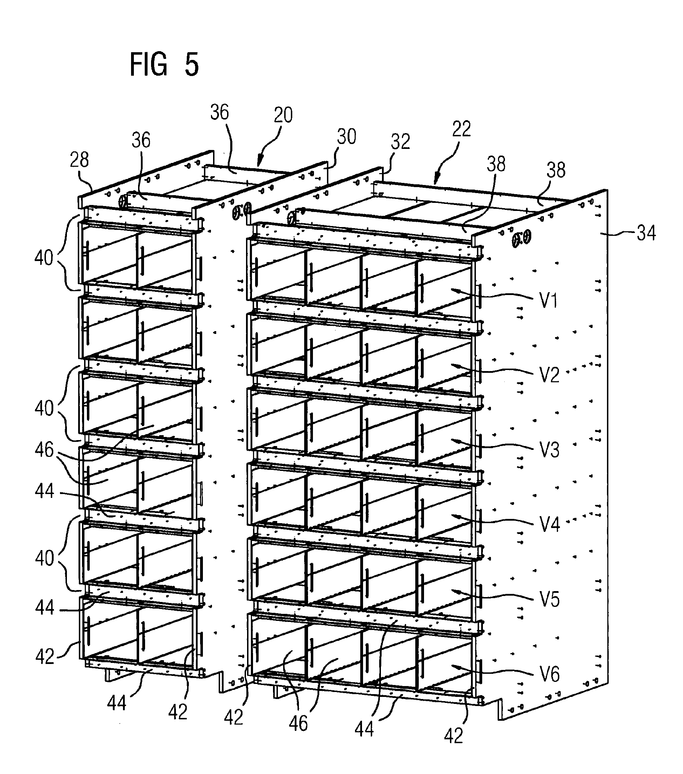

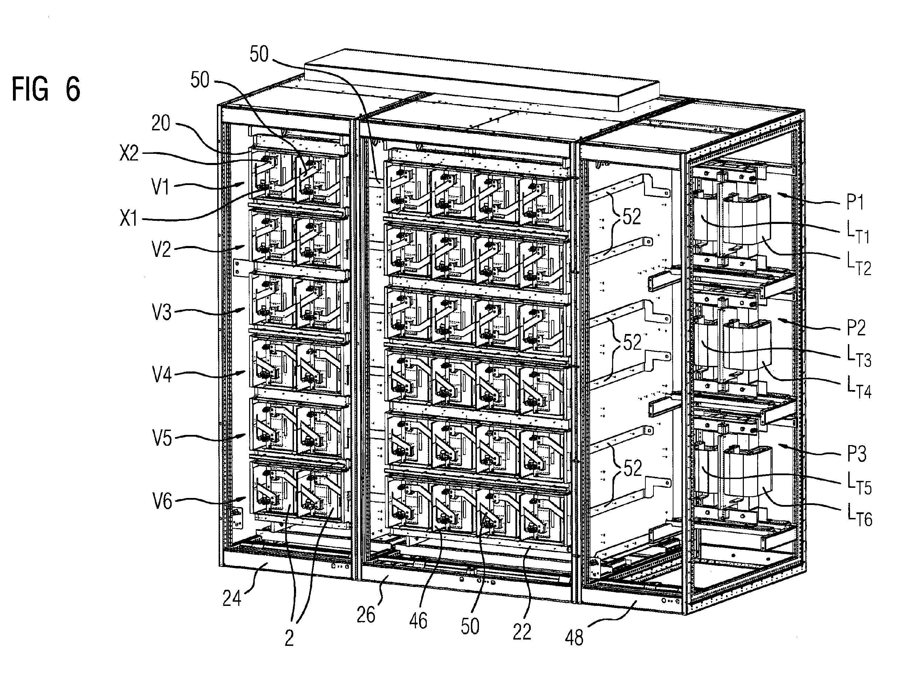

Aus der EP 1 920 528 B1 ist eine weitere Ausgestaltung des Zellenstromrichters der Siemens-Broschüre bekannt, der anstelle einer sechspulsigen Diodenbrücke einer jeden Stromrichterzelle einen selbstgeführten Pulsstromrichter aufweist. Ein derartiger selbstgeführter Pulsstromrichter einspeiseseitig wird auch als Active Front End (AFE) bezeichnet. Durch die Verwendung eines AFEs für jede Stromrichterzelle dieses dreiphasigen Zellenstromrichters kann nun Energie in ein Netz zurückgespeist werden. Außerdem kann dieser AFE derart gesteuert werden, dass der Leistungsfaktor cos=1 ist und dass die Zwischenkreisspannung einer jeden Stromrichterzelle konstant auf einem vorbestimmten Betragswert geregelt werden kann. Eine Stromrichterzelle als Baueinheit ist in FIG 5 dieses EP-Patents dargestellt. In FIG 6 dieses EP-Patents ist eine Tragkonstruktion für die Aufnahme mehrerer Stromrichterzellen dargestellt. Diese Tragkonstruktion umfasst mehrere Trägerschienen, eine Rückwandleiterplatte, jeweils zwei Führungsschienen für eine Stromrichterzelle und zwei Seitenwände. Die Rückwandleiterplatte weist für jede Stromrichterzelle Anschlüsse auf. Die Führungsschienen für die Stromrichterzellen sind in drei Etagen auf den Trägerschienen angeordnet, die die beiden Seitenwände dieser Tragkonstruktion mechanisch miteinander verbinden. Diese Tragkonstruktion ist für einen dreiphasigen Zellenstromrichter mit jeweils drei Stromrichterzellen pro Phase ausgebildet. Ob diese Stromrichterzellen einer Phase in einer Etage nebeneinander oder über drei Etagen übereinander angeordnet werden, kann diesem EP-Patent nicht entnommen werden.

Wird ein Zellenstromrichter mit einer höheren Ausgangsspännung benötigt, die amplitudenmäßig über den Wert der Ausgangsspannung des Zellenstromrichters der Siemens-Broschüre liegt, muss wenigstens eine weitere Stromrichterzelle pro Phase vorgesehen sein. Um einen derartigen Zellenstromrichter mit jeweils fünf Stromrichterzellen pro Phase herstellen zu können, muss der Ventilschrank um eine Stromrichterzellen-Breite erweitert werden. Gleichzeitig muss der Stromrichter-Transformator mit weiteren drei dreiphasigen Sekundärwicklungssystemen versehen werden. Diese drei weiteren Stromrichterzellen müssen jeweils mit einem weiteren dreiphasigen Sekundärwicklungssystem des Stromrichter-Transformators speiseseitig elektrisch leitend verbunden werden und ausgangsseitig mit den bereits vorhandenen vier Stromrichterzellen einer Phase elektrisch in Reihe geschaltet werden.

Der Siemens-Broschüre "Der wassergekühlte Mittelspannungsumrichter der Wahl" mit der Bestell-Nr. E20001-A40-P590, veröffentlicht im Juli 2009, kann entnommen werden, wie sich die Gesamtbreite eines Spannungszwischenkreis-Umrichters mit lastseitigem Zellenstromrichter mit Erhöhung der Umrichter-Ausgangsspannung erhöht, wobei die Veränderung vom Breitenzuwachs des Ventilschranks abhängt. Gemäß den beiden genannten Broschüren weist die Stromrichter-Familie "ROBICON Perfect Harmony" für unterschiedliche Ausgangsspannungen jeweils einen Umrichter mit mehreren Schränken auf. Diese Umrichter-Familie kann nicht individuell an beliebige Ausgangsspannungen angepasst werden.

Der Erfindung liegt deshalb die Aufgabe zugrunde, ein modulares Stromrichterschranksystem für einen Stromrichter mit einer Vielzahl von Stromrichterzellen anzugeben, das einfach an unterschiedliche Stromrichter-Ausgangsspannungen individuell angepasst werden kann.

Diese Aufgabe wird erfindungsgemäß mit den Merkmalen des Anspruchs 1 gelöst.

Dadurch, dass die Stromrichterzellen der Stromrichterventile der Phasenmodule eines eingangs genannten Stromrichters in zwei Ventilschränken untergebracht werden, wobei die Zweigdrosseln zusätzlich in einem separaten Drosselschrank verbaut sind, kann jeder Ventilschrank einzeln mit dem Drosselschrank oder eine Kombination der beiden Ventilschränke mit dem Drosselschrank oder eine Kombination eines Ventilschranks mit dem Drosselschrank zu einem Stromrichterschrank kombiniert werden. Durch die Verwendung wenigstens eines ersten und / oder zweiten Ventilschranks kann eine Stromrichterkonstruktion an eine geforderte Stromrichter-Ausgangsspannung angepasst werden.

Bei einer vorteilhaften Ausführungsform des modularen Stromrichterschranksystems weist ein erster Ventilschrank zwei Waben-Zellen pro Ventiletage auf, wogegen ein zweiter Ventilschrank vier Waben-Zellen pro Ventiletage aufweist. Dadurch weist der zweite Ventilschrank pro Ventiletage doppelt so viele Waben-Zellen auf, wodurch mittels Kombination des ersten und des zweiten Ventilschranks bzw. des ersten und mehrerer zweiter Ventilschränke Stromrichterventile eines Zellenstromrichters mit einer Anzahl von zwei, vier, sechs, acht, ... Stromrichterzellen aufgebaut werden können. Das heißt, die Stromrichter-Ausgangsspannung kann in Schritten von jeweils zwei Zellenspannungen erhöht werden. Dadurch kann das erfindungsgemäße modulare Stromrichterschranksystem ohne großen Aufwand an eine erforderliche Stromrichter-Ausgangsspannung individuell angepasst werden.

Wie bereits erwähnt, weist jeder Ventilschrank mehrere Ventiletagen auf, die übereinander beabstandet sind. In jeder Ventiletage werden die Stromrichterzellen eines Stromrichterventils eines Phasenmoduls des eingangs genannten Zellenstromrichters untergebracht. Bei einer dreiphasigen Ausführungsform weist dieser Zellenstromrichter drei Phasenmodule mit jeweils zwei Stromrichterventilen auf. Jedes Phasenmodul weist ebenfalls zwei Zweigdrosseln auf, die mit einem oberen oder einem unteren Stromrichterventil elektrisch leitend verbunden sind. Ein Verbindungspunkt dieser beiden Zweigdrosseln bildet einen Phasenausgang L1 bzw. L2 bzw. L3, an dem ein Anschluss einer Last anschließbar ist. Somit weist der erste und zweite Ventilschrank sechs Ventiletagen auf. In welcher Ventiletage die Stromrichterzellen einer der sechs Stromrichterventile untergebracht werden, ist zunächst nicht zwingend vorgeschrieben.

Wird jedoch Wert gelegt auf eine einfache gleichspannungsseitige und/oder drosselseitige Verschienung, ist eine Unterbringung der Stromrichterzellen jeweils eines Stromrichterventils des Zellenstromrichters nicht mehr beliebig.

Bei einer vorteilhaften Ausführungsform sind die Stromrichterzellen eines oberen und eines unteren Stromrichterventils jeweils eines Phasenmoduls des mehrphasigen Zellenstromrichters in benachbarten Ventiletagen untergebracht. Dadurch kann jede Ventiletage drosselseitig direkt mit einer Zweigdrossel einer entsprechenden Phasenetage des Drosselschranks elektrisch leitend verbunden werden. Die Verschienung gleichspannungsseitig ist komplexer, da die Stromrichterventile, die mit einem Gleichspannungspotential elektrisch leitend verbunden sind, in jeder zweiten Ventiletage des Ventilschranks angeordnet sind.

Bei einer weiteren vorteilhaften Ausführungsform des modularen Stromrichterschranksystems sind die Stromrichterventile der Phasenmodule des eingangs genannten Zellenstromrichters derart auf die Ventiletagen eines Ventilschranks verteilt, dass die Stromrichterzelle der oberen Stromrichterventile der drei Phasenmodule in den drei oberen Ventiletagen, und die Stromrichterzellen der unteren Stromrichterventile der drei Phasenmodule in den drei unteren Ventiletagen untergebracht sind. Dadurch sind die Stromschienen eines positiven Gleichspannungspotentials und die Stromschienen eines negativen Gleichspannungspotentials räumlich voneinander getrennt. Das heißt, die gleichspannungsseitige Verschienung der Ventiletagen eines Ventilschranks fällt besonders einfach aus. Es muss jedoch in Kauf genommen werden, dass die drosselseitige Verschienung komplexer ausfällt.

Bei einer weiteren vorteilhaften Ausführungsform des modularen Stromrichterschranksystems sind die Stromrichterzellen der unteren Stromrichterventile der drei Phasenmodule des Zellenstromrichters in den oberen drei Ventiletagen eines Ventilschranks untergebracht, so dass die Stromrichterzellen der oberen Stromrichterventile der drei Phasenmodule nun in den unteren drei Ventiletagen des Ventilschranks untergebracht sind. Dabei sind die Stromrichterzellen der unteren Stromrichterventile in den oberen Ventiletagen und die Stromrichterzellen der oberen Stromrichterventile in den unteren Ventiletagen derart verteilt, dass die Stromrichterzellen eines unteren und oberen Stromrichterventils eines Phasenmoduls in benachbarten Ventiletagen untergebracht sind. Dadurch bleibt die Verschienung auf der Gleichspannungsseite des Ventilschranks unverändert einfach, wobei die Potentiale vertauscht sind. Die Verschienung drosselseitig vereinfacht sich bei dieser Anordnung, da wenigstens die Stromrichterventile eines Phasenmoduls in benachbarten Ventiletagen untergebracht sind, wodurch die zugehörigen Zweigdrosseln im Drosselschrank direkt mit diesen Stromrichterventilen verknüpft werden können.

Die Ausgestaltung einer Tragkonstruktion eines Ventilschranks, in der eine Vielzahl von Stromrichterzellen eines Zellenstromrichters untergebracht werden, ist den Unteransprüchen 14 bis 18 entnehmbar.

Da innerhalb eines Ventilschranks unterschiedliche Spannungspotentiale auftreten, besteht die Tragkonstruktion aus elektrisch isolierendem Material. Diese Tragkonstruktion ist derart ausgestaltet, dass in jeder Ventiletage eine entsprechende Anzahl von Waben-Zellen nebeneinander angeordnet sind. Diese Waben-Zellen sind derart bemessen, dass jede Waben-Zelle eine Stromrichterzelle eines Stromrichterventils aufnehmen kann. Durch die wabenförmige Ausgestaltung sind die aufgenommenen Stromrichterzellen ringsum abgeschottet, so dass Folgen eines Stromrichterzellenfehlers lokal beschränkt bleiben.

Zur weiteren Erläuterung der Erfindung wird auf die Zeichnung Bezug genommen, in der eine Ausführungsform eines erfindungsgemäßen modularen Stromrichterschranksystems schematisch veranschaulicht ist.
- FIG 1: zeigt ein Ersatzschaltbild eines dreiphasigen Zellenstromrichters, in der
- FIG 2: ist ein Ersatzschaltbild einer Stromrichterzelle des Zellenstromrichters nach FIG 1 dargestellt, die
- FIG 3: zeigt ein weiteres Ersatzschaltbild einer Stromrichterzelle des Zellenstromrichters nach FIG 1, die
- FIG 4: zeigt eine Stromrichterzelle des Zellenstromrichters nach FIG 1, in der
- FIG 5: sind die Tragkonstruktionen eines ersten und zweiten Ventilschranks des modularen Stromrichterschranksystems nach der Erfindung perspektivisch nebeneinander dargestellt, die
- FIG 6: zeigt eine Ausführungsform eines modularen Stromrichterschranks des modularen Stromrichterschranksystems, wobei in den
- FIG 7-9: unterschiedliche Belegungspläne der Ventiletagen des Zellenstromrichters nach FIG 1 dargestellt sind.

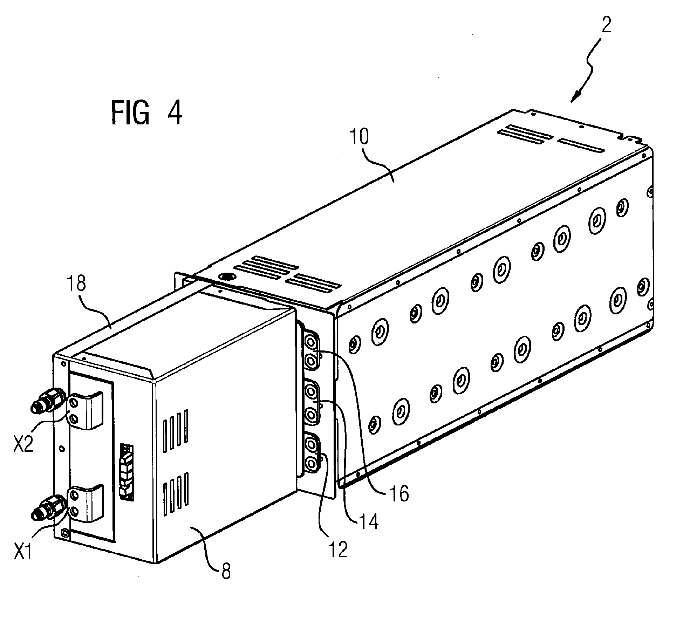

In FIG 4 ist eine Stromrichterzelle 2 entsprechend dem Ersatzschaltbild gemäß FIG 3 dargestellt. Diese Stromrichterzelle 2 weist zwei Baueinheiten auf, nämlich eine Halbleiter-Baueinheit 8 und eine Kondensator-Baueinheit 10. Diese beiden Baueinheiten 8 und 10 sind mechanisch und elektrisch miteinander verbunden. Die Kondensator-Baueinheit 10 weist neben einer Vielzahl von Elektrolytkondensatoren auch ein Stromschienenpaket auf, mit dem diese Elektrolytkondensatoren miteinander elektrisch in Reihe und/oder elektrisch parallel geschaltet sind. Gemäß dem Ersatzschaltbild der FIG 3 weist die Kondensator-Baueinheit 10 drei Anschlüsse auf, die mit drei Anschlüssen 12,14 und 16 der Halbleiter-Baueinheit 8 elektrisch leitend verbunden sind. In dieser Halbleiter-Baueinheit 8 sind neben den Halbleitern T₁₁, T₁₂, T₂₁, T₂₂, D₁₁, D₁₂, D₂₁ und D₂₂ ein Stromschienenpaket und ein Kühlkörper 18 für diese genannten Halbleiter untergebracht. Mit diesem Stromschienenpaket werden diese abschaltbaren Halbleiter T₁₁, T₁₂, T₂₁, T₂₂ und deren Freilauf-Dioden D₁₁, D₁₂, D₂₁ und D₂₂ miteinander entsprechend dem Ersatzschaltbild der FIG 3 verschaltet.

In FIG 5 sind zwei Tragkonstruktionen 20 und 22 eines ersten und zweiten Ventilschranks 24 und 26 dargestellt. Jede Tragkonstruktion 20 und 22 weist zwei Seitenwände 28 und 30 bzw. 32 und 34 auf, die mittels Abstandsstreben 36 bzw. 38 voneinander beabstandet sind. Von diesen Abstandsstreben 36 und 38 sind nur die oberen in dieser Darstellung zu sehen. Die Seitenwände 28, 30, 32 und 34 weisen frontseitig eine Vielzahl von Ausnehmungen 40 auf, die jeweils in den Schmalseiten 42 der Seitenwände 28, 30, 32 und 34 angeordnet sind. In jeweils einer Ausnehmung 40 zweier Seitenwände 28, 30 bzw. 32, 34 einer Tragkonstruktion 20 bzw. 22 eines ersten bzw. zweiten Ventilschranks 24 bzw. 26 ist eine Querstrebe 44 angeordnet. Jeweils zwischen zwei Querstreben 44 befindet sich eine Ventiletage V1, V2, V3, V4, V5, V6, die jeweils gemäß der Tragkonstruktion 20 des ersten Ventilschranks 24 zwei Waben-Zellen 46 und gemäß der Tragkonstruktion 22 des zweiten Ventilschranks 26 jeweils vier Waben-Zellen 46 aufweisen. Jede Waben-Zelle 46 ist derart ausgestaltet, dass eine Stromrichterzelle 2 gemäß FIG 4 aufgenommen werden kann.

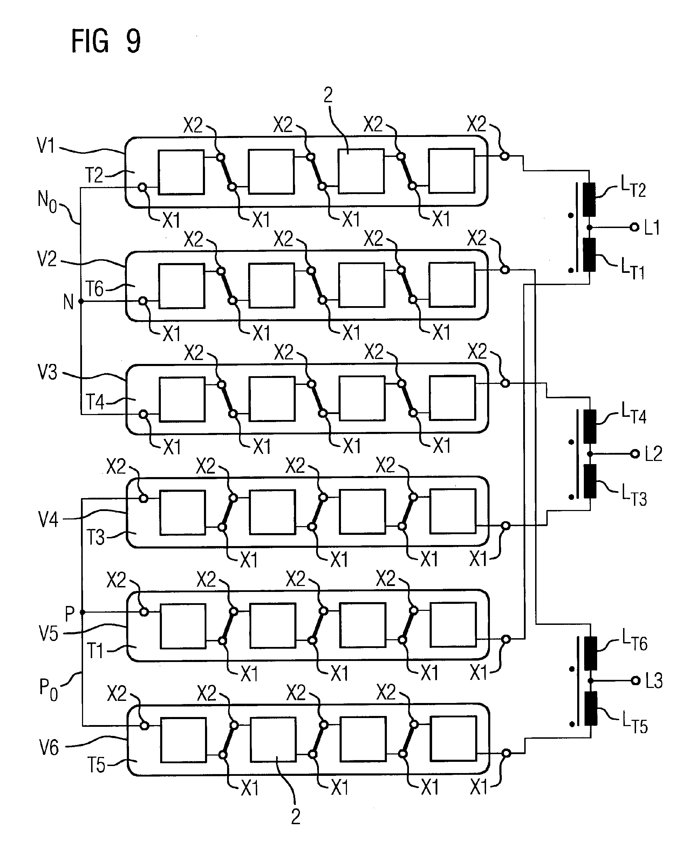

In FIG 6 ist eine Ausführungsform eines erfindungsgemäßen modularen Stromrichterschranksystems näher dargestellt. Dieses modulare Stromrichterschranksystem weist einen ersten Ventilschrank 24, einen zweiten Ventilschrank 26 und einen Drosselschrank 48 auf. Im ersten Ventilschrank 24 ist die Tragkonstruktion 20 der FIG 4 untergebracht, wobei bereits jede Waben-Zelle 46 dieser Tragkonstruktion 20 eine Stromrichterzelle 2 des modularen dreiphasigen Zellenstromrichters gemäß FIG 1 aufweist. Die Tragkonstruktion 22 der FIG 4 ist im zweiten Ventilschrank 26 untergebracht. Auch deren Waben-Zellen 46 sind mit Stromrichterzellen 2 des modularen dreiphasigen Zellenstromrichters gemäß FIG 1 bestückt. Gemäß der Ausführungsform des modularen Zellenstromrichters der FIG 1 sind die Stromrichterzellen 2 eines jeden Stromrichterventils T1,...,T6 elektrisch in Reihe geschaltet. Diese Reihenschaltung von Stromrichterzellen 2 wird mittels Stromschienen 50 frontseitig dieser beiden Ventilschränke 24 und 26 bewerkstelligt. Dazu verbindet jeweils eine Stromschiene 50 den Anschluss X1 einer ersten Stromrichterzelle 2 mit dem Anschluss X2 einer nächsten Stromrichterzelle 2 jeweils innerhalb einer Ventiletage V1,...,V6. Die Anschlüsse X1 bzw. X2 der zweiten Stromrichterzelle 2 einer jeden Ventiletage V1,...,V6 des ersten Ventilschranks 24 ist mittels einer Stromschiene 50 mit dem Anschluss X2 bzw. X1der ersten Stromrichterzelle 2 einer jeden Ventiletage V1,...,V6 elektrisch leitend verbunden. Der Anschluss X2 bzw. X1 der vierten Stromrichterzelle 2 einer jeden Ventiletage V1,...,V6 des zweiten Ventilschranks 26 ist jeweils mittels einer Stromschiene 52 mit einer Zweigdrossel L_{T1},.... L_{T6} des Drosselschranks 48 elektrisch leitend verbunden. Jeweils ein Verbindungspunkt zweier Zweigdrosseln L_{T1}, L_{T2} bzw. L_{T3}, L_{T4} bzw. L_{T5}, L_{T6} einer jeden Phasenetage P1, P2 bzw. P3 wird beispielsweise rückwärtig nach oben oder nach unten aus diesem Drosselschrank 48 herausgeführt, so dass eine Drehfeldmaschine angeschlossen werden kann. Bei dieser Ausführungsform der beiden Ventilschränke 24 und 26 des erfindungsgemäßen modularen Stromrichterschranksystems sind die Waben-Zellen 46 der Ventiletagen V1,...,V6 gemäß Belegungsplan gemäß FIG 9 mit Stromrichterzellen gemäß FIG 4 bestückt. Dieses in FIG 6 dargestellte modulare Stromrichterschranksystem weist gegenüber dem Ersatzschaltbild des modularen Zellenstromrichters gemäß FIG 1 sechs Stromrichterzellen 2 pro Stromrichterventil T1,...,T6 anstelle von vier Stromrichterzellen 2 auf, die auf den ersten und zweiten Ventilschrank 24 und 26 verteilt sind. Würde der Stromrichter gemäß Ersatzschaltbild gemäß FIG 1 als Stromrichterschranksystem realisiert, so müsste nur der zweite Ventilschrank 26 mit dem Drosselschrank 48 verschaltet werden. Eine weitere Ausführungsform dieses Stromrichterschranksystem besteht darin, dass der erste Ventilschrank 24 mit dem Drosselschrank 48 verschaltet wird. Bei weiteren Ausführungsformen des Stromrichterschranksystem sind wenigstens zwei zweite Ventilschränke 26 mit einem Drosselschrank 48 bzw. wenigstens zwei zweite Ventilschränke 26 und ein erster Ventilschrank 24 und ein Drosselschrank 48 miteinander elektrisch leitend verbunden.

Mit Hilfe von zwei Ventilschrank-Grundtypen (Ventilschränken 24 und 26) und einem Drosselschrank 48 kann jeweils ein Stromrichterschranksystem aufgebaut werden, der sich jeweils durch die Anzahl der verwendeten Stromrichterzellen 2 unterscheidet. Die einzelnen Konfigurationen der Stromrichterschranksysteme unterscheiden sich jeweils durch zwei Stromrichterzellen 2 pro Stromrichterventil T1,...,T6. Das heißt, dass die Stromrichter-Ausgangsspannung von Konfiguration zu Konfiguration um eine doppelte Zellenspannung U_{X21} erhöht ist. Somit kann ein Stromrichterschranksystem erstellt werden, der individuell an eine gewünschte Stromrichterspannung einfach angepasst werden kann.

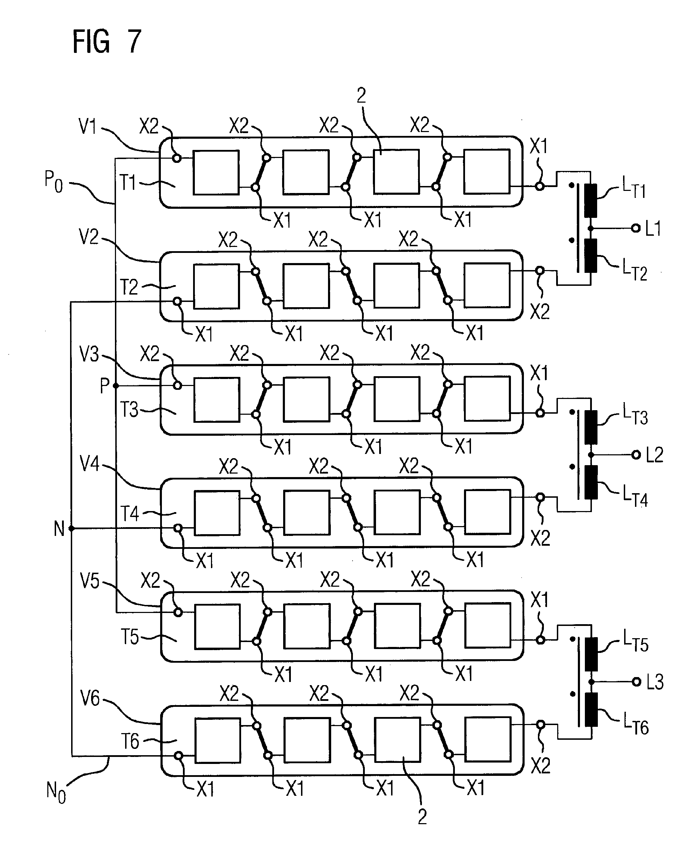

Die FIG 7 zeigt einen ersten Belegungsplan der sechs Ventiletagen V1,...,V6 mit Stromrichterzellen 2 des modularen Stromrichters gemäß Ersatzschaltbild der FIG 1. Gemäß diesem Ersatzschaltbild weist jedes Stromrichterventil T1,...,T6 vier Stromrichterzellen 2 auf, die elektrisch in Reihe geschaltet sind. Gemäß diesem Ersatzschaltbild sind die drei oberen Stromrichterventile T1, T3 und T5 jeweils mit einem ersten Anschluss an eine positive Potentialschiene P₀ angeschlossen, während ihre zweiten Anschlüsse mit einem Anschluss einer Zweigdrossel L_{T1}, L_{T3} oder L_{T5} elektrisch leitend verbunden sind. Die unteren Stromrichterventile T2, T4 und T6 sind jeweils mit einem ersten Anschluss an eine negative Potentialschiene N₀ angeschlossen, während ihre zweiten Anschlüsse jeweils mit einem Anschluss einer Zweigdrossel L_{T2}, L_{T4} oder L_{T6} elektrisch leitend verbunden sind. Jeweils ein Verbindungspunkt zweier Zweigdrosseln L_{T1}, L_{T2} bzw. L_{T3}, L_{T4} bzw. L_{T5}, L_{T6} einer Phase 1 bzw. 3 bzw. 5 bildet einen Stromrichterausgang L₁ bzw. L₂ bzw. L₃.

Die beiden Ventilschränke 24 und 26 weisen für jedes Stromrichterventil T1,..., T6 eine Ventiletage V1,...V6 auf, die beispielsweise von oben nach unten durchnummeriert sind. Jeder dreiphasige modulare Zellenstromrichter weist sechs Stromrichterventile T1,...,T6 auf, wogegen ein einphasiger modularer Zellenstromrichter nur vier Stromrichterventile T1,...,T6 aufweist. Somit müssen die beiden Ventilschränke 24 und 26 entsprechend der Anzahl vorhandener Stromrichterventile T1,...,T6 Ventiletagen V1,...,V6 aufweisen, die entweder auf- oder absteigend im Ventilschrank 24 bzw. 26 übereinander angeordnet sein müssen. In den drei Belegungsplänen gemäß der FIG 7 bis 9 sind die sechs Ventiletagen beginnend unten absteigend (beginnend oben aufsteigend) angeordnet.

Gemäß dem Belegungsplan der FIG 7 sind die Stromrichterzellen 2 des Stromrichterventils T1 in der ersten Ventiletage V1 und die des Stromrichterventils T2 in der zweiten Ventiletage V2 angeordnet. Die Stromrichterzellen 2 der Stromrichterventile T3 bzw. T4 des zweiten Phasenmoduls 3 sind in der Ventiletage V3 bzw. V4 angeordnet. Die Stromrichterzellen 2 der Stromrichterventile T5 und T6 des dritten Phasenmoduls 5 des modularen Stromrichters sind in den Ventiletagen V5 und V6 angeordnet. Das heißt, dass die Stromrichterzellen 2 der Stromrichterventile T1, T2 bzw. T3, T4 bzw. T5, T6 eines jeden Phasenmoduls 1 bzw. 3 bzw. 5 in zwei benachbarten Ventiletagen V1, V2 bzw. V3, V4 bzw. V5, V6 untergebracht sind. Mit diesem Belegungsplan können die Zweigdrosseln L_{T1}, L_{T2} bzw. L_{T3}, L_{T4} bzw. L_{T5}, L_{T6} eines jeden Phasenmoduls 1, 3 und 5 mit den Stromrichterventilen T1, T2 bzw. T3, T4 bzw. T5, T6 der entsprechenden Phasenmodule verschaltet werden. Das heißt, die Verschienung der Zweigdrossel-Anschlüsse fällt besonders einfach aus. Die Verschienung der oberen Stromrichterventile T1, T3 und T5 und der unteren Stromrichterventile T2, T4 und T6 fällt etwas aufwändiger aus, da die Stromrichterventile T1, T3 und T5 bzw. T2, T4, T6, die mit der positiven bzw. negativen Potentialschiene P₀ bzw. N₀ elektrisch leitend verbunden sind, in beabstandeten Ventiletagen V1, V3, V5 bzw. V2, V4, V6 angeordnet sind.

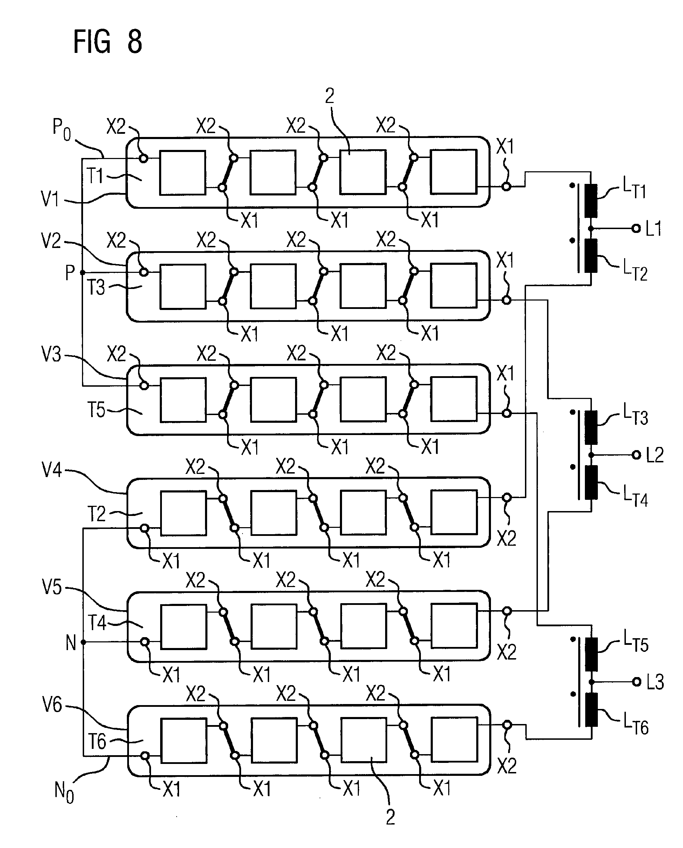

Während hingegen gemäß Belegungsplan der FIG 8 die Stromrichterzellen 2 der oberen Stromrichterventile T1, T3 und T5 in benachbarte obere Ventiletagen V1, V2 und V3 und die Stromrichterzellen 2 der unteren Stromrichterventile T2, T4 und T6 in untere benachbarte Ventiletagen V4, V5 und V6 untergebracht sind, vereinfacht sich die gleichspannungsseitig Verschienung, wobei die positive und negative Potentialschiene P₀ und N₀ zueinander beabstandet angeordnet werden können. Nachteilig an diesem Belegungsplan ist die komplexere Verschienung der Zweigdrosseln L_{T1},..., L_{T6}, da immer die beiden Stromrichterventile T1, T2 bzw. T3, T4 bzw. T5, T6 eines Phasenmoduls immer durch zwei Ventiletagen V2,V3 bzw. V3,V4 bzw. V4,V5 voneinander räumlich getrennt sind.

In FIG 9 ist ein weiterer Belegungsplan der Ventiletagen V1,...,V6 der Ventilschränke 24 und 26 mit Stromrichterzellen 2 der Stromrichterventile T1,...,T6 dargestellt. Dieser Belegungsplan unterscheidet sich vom Belegungsplan gemäß FIG 8 dadurch, dass die Anordnung der oberen und unteren Stromrichterventile T1, T3, T5 und T2, T4, T6 innerhalb des Ventilschranks 24 bzw. 26 getauscht worden sind. Das heißt, die oberen Stromrichterventile T1, T3, T5 sind nun in den unteren Ventiletagen V4, V5 und V6 und die unteren Stromrichterventile T2, T4, T6 des modularen Stromrichters gemäß FIG 1 sind in den oberen Ventiletagen V1, V2, V3 angeordnet. Zusätzlich sind die Unterbringung der Stromrichterzellen 2 der Stromrichterventile T4,T6 und T1,T3 in den Ventiletagen V2,V3 und V4,V5 derart getauscht, dass nun in den benachbarten Ventiletagen V3 und V4 die Stromrichterventile T4 und T3 des Phasenmoduls 3 untergebracht sind. Dadurch können die Zweigdrosseln L_{T3} und L_{T4} des zweiten Phasenmoduls 3 direkt mit einem Anschluss des Stromrichterventils T3 und T4 elektrisch leitend verbunden werden. Somit vereinfacht sich die komplexe Verschienung des Belegungsplans gemäß FIG 8, ohne dass die einfache gleichspannungsseitige Verschienung abgeändert wird.

Dadurch, dass die Stromrichterzellen 2 eines jeden Stromrichterventils T1,...,T6 eines modularen mehrphasigen Zellenstromrichters jeweils in einer Ventiletage V1,...,V6 nebeneinander angeordnet sind, und erfindungsgemäß zwei unterschiedliche Ventilschränke 24 und 26 gemeinsam oder einzeln mit einem Drosselschrank 48 verschient werden, kann jeder modulare mehrphasige Zellenstromrichter ohne großen Aufwand an erforderliche Stromrichter-Ausgangsspannungen individuell angepasst werden.

## Patentansprüche

1. Modulares Stromrichterschranksystem eines Stromrichters mit wenigstens einem ein oberes und ein unteres Stromrichterventil (T1,..., T6) aufweisenden Phasenmodul (1,3,5), **dadurch gekennzeichnet, dass** jedes Stromrichterventil (T1,...,T6) wenigstens zwei Stromrichterzellen (2) und eine Zweigdrossel (L_{T1},..., L_{T6}) aufweist, die elektrisch in Reihe geschaltet sind, umfassend einen ersten Ventilschrank (24), einen zweiten Ventilschrank (26) und einen Drosselschrank (48), wobei die Ventilschränke (24,26) jeweils mehrere übereinander beabstandete mehrere nebeneinander angeordnete Waben-Zellen (46) aufweisenden Ventiletagen (V1,...,V6) aufweisen, wobei der Drosselschrank (48) mehrere übereinander beabstandete Phasenetagen (P1,P2,P3) aufweist, und wobei jeweils zwei Ventiletagen (V1, V2; V3, V4; V5, V6) wenigstens eines Ventilschranks (24,26) jeweils mit einer Phasenetage (P1,P2,P3) des Drosselschranks (48), die nebeneinander angeordnet sind, elektrisch leitend verbunden sind.

2. Modulares Stromrichterschranksystem nach Anspruch 1, **dadurch gekennzeichnet, dass** der erste Ventilschrank (24) zwei Waben-Zellen (46) pro Ventiletage (V1,...,V6) aufweist.

3. Modulares Stromrichterschranksystem nach Anspruch 1, **dadurch gekennzeichnet, dass** der zweite Ventilschrank (26) vier Waben-Zellen (46) pro Ventiletage (V1,...,V6) aufweist.

4. Modulares Stromrichterschranksystem nach Anspruch 1, **dadurch gekennzeichnet, dass** die Stromrichterzellen (2) eines oberen und unteren Ventilzweigs (T1, T2; T3,T4;T5,T6) jeweils eines Phasenmoduls (1,3,5) in Waben-Zellen (46) benachbarter Ventiletagen (V1,V2;V3,V4; V5,V6) eines Ventilschranks (24,26) angeordnet sind.

5. Modulares Stromrichterschranksystem nach Anspruch 1, **dadurch gekennzeichnet, dass** die Strom-richterzellen (2) jeweils eines oberen Stromrichterventils (T1,T3,T5) der Phasenmodule (1,3,5) des Stromrichters und die Stromrichterzellen (2) jeweils eines unteren Stromrichterventils (T2,T4,T6) der Phasenmodule (1,3,5) des Stromrichters jeweils in benachbarten Ventiletagen (V1,V2,V3;V4,V5,V6) eines Ventilschranks (24,26) angeordnet sind.

6. Modulares Stromrichterschranksystem nach Anspruch 5, **dadurch gekennzeichnet, dass** die Stromrichterzellen (2) der oberen Stromrichterventile (T1,T3,T5) in den oberen Ventiletagen (V1,V2,V3) eines Ventilschranks (24,26) angeordnet sind, wobei die Reihenfolge der Reihenfolge der Phasemodule (1,3,5) des Stromrichters entspricht.

7. Modulares Stromrichterschranksystem nach Anspruch 5, **dadurch gekennzeichnet, dass** die Stromrichterzellen (2) der unteren Stromrichterventile (T2,T4,T6) in den oberen Ventiletagen (V1,V2,V3) eines Ventilschranks (24,26) angeordnet sind, wobei die Reihenfolge der unteren und oberen Stromrichterventile (T2,T4,T6;T1,T3,T5) der Phasenmodule (1,3,5) in oberen und unteren Ventiletagen (V1,V2, V3;V4,V5, V6) des Ventilschranks (24,26) derart gewählt ist, dass ein unteres und ein oberes Stromrichterventil (T4,T3) eines Phasenmoduls (1,3,5) in benachbarten Ventiletagen (V3,V4) angeordnet sind.

8. Modulares Stromrichterschranksystem nach Anspruch 1 und 2, **dadurch gekennzeichnet, dass** der erste Ventilschrank (24) und der Drosselschrank (48) miteinander elektrisch leitend verbunden sind.

9. Modulares Stromrichterschranksystem nach Anspruch 1 und 3, **dadurch gekennzeichnet, dass** der zweite Ventilschrank (26) und der Drosselschrank (48) miteinander elektrisch leitend verbunden sind.

10. Modulares Stromrichterschranksystem nach Anspruch 1,2 und 3, **dadurch gekennzeichnet, dass** der erste Ventilschrank (24), der zweite Ventilschrank (26) und der Drosselschrank (48) miteinander elektrisch leitend verbunden sind.

11. Modulares Stromrichterschranksystem nach Anspruch 1 und 3, **dadurch gekennzeichnet, dass** zwei zweite Ventilschränke (26) und der Drosselschrank (48) miteinander elektrisch leitend verbunden sind.

12. Modulares Stromrichterschranksystem nach Anspruch 1, 2 und 3, **dadurch gekennzeichnet, dass** ein erster Ventilschrank (24), zwei zweite Ventilschränke (26) und der Drosselschrank (48) miteinander elektrisch leitend verbunden sind.

13. Modulares Stromrichterschranksystem nach Anspruch 1 und 3, **dadurch gekennzeichnet, dass** drei zweite Ventilschränke (26) und der Drosselschrank (48) miteinander elektrisch leitend verbunden sind.

14. Modulares Stromrichterschranksystem nach Anspruch 13, **dadurch gekennzeichnet, dass** die Ventiletagen (V1,...,V6) eines Ventilschranks (24,26) zwischen zwei Seitenwänden (28,30;32,34) übereinander beabstandet angeordnet sind.

15. Modulares Stromrichterschranksystem nach Anspruch 14, **dadurch gekennzeichnet, dass** die beiden Seitenwände (28,30;32,34) mittels zweier Abstandsstreben (36,38) oberhalb der oberen Ventiletage (V1) und zweier Abstandsstreben (36,38) unterhalb der unteren Ventiletage (V6) beabstandet sind.

16. Modulares Stromrichterschranksystem nach Anspruch 14, **dadurch gekennzeichnet, dass** jede Seitenwand (28,30;32,34) frontseitig für jede Ventiletage (V1,...,V6) eine Ausnehmung (40) aufweist.

17. Modulares Stromrichterschranksystem nach Anspruch 16, **dadurch gekennzeichnet, dass** jeweils in den Ausnehmungen (40) zweier auf Abstand gehaltener Seitenwände (28,30;32,34) Querstreben (44) angeordnet sind.

18. Modulares Stromrichterschranksystem nach einem der Ansprüche 14 bis 17, **dadurch gekennzeichnet, dass** die aus Seitenwänden (28,30;32,34), Abstandsstreben (36,38) und Querstreben (44) gebildete Tragkonstruktion (20,22) einer Vielzahl von Stromrichterzellen (2) eines Ventilschranks (24,26) aus elektrisch isolierendem Material besteht.

19. Modulares Stromrichterschranksystem nach Anspruch 1, **dadurch gekennzeichnet, dass** als Stromrichterzelle (2) ein zweipoliges Subsystem (4) vorgesehen ist, das zwei elektrisch in Reihe geschaltete abschaltbare Halbleiter (T₁₁,T₁₂) jeweils mit einer antiparallel geschalteten Diode (D₁₁,D₁₂) und einem Speicherkondensator (C_{SM}) aufweist, wobei der dieser Reihenschaltung elektrisch zu dieser Reihenschaltung geschaltet ist.

20. Modulares Stromrichterschranksystem nach Anspruch 1, **dadurch gekennzeichnet, dass** als Stromrichterzelle (2) ein Doppel-Submodul (6) vorgesehen ist, das vier elektrisch in Reihe geschaltete abschaltbare Halbleiter (T₁₁, T₁₂, T₂₁, T₂₂) jeweils mit einer antiparallel geschalteten Diode ((D₁₁,D₁₂,D₂₁D₂₂) und zwei Speicherkondensatoren (C_{SM}) aufweist, wobei diese beiden Speicherkondensatoren (C_{SM}) einerseits elektrisch in Reihe und andererseits jeweils eine Reihenschaltung zweier abschaltbarer Halbleiter (T₁₁, T₂₁; T₂₁, T₂₂) elektrisch parallel geschaltet sind.

## Claims

1. Modular converter cabinet system of a converter with at least one phase module (1, 3, 5) having an upper and a lower converter valve (T1,...,T6), **characterised in that** each converter valve (T1,...,T6) has at least two converter cells (2) and a branch inductor (L_{T1}, ... , L_{T6}) which are electrically connected in series, comprising a first valve cabinet (24), a second valve cabinet (26) and an inductor cabinet (48), wherein the valve cabinets (24, 26) each have a number of valve levels (V1,...,V6) spaced apart vertically from one another having honeycomb cells (46) arranged next to one another, wherein the inductor cabinet (48) has a number of phase levels (P1, P2, P3) spaced apart above one another, and wherein two valve levels (V1, V2; V3, V4; V5, V6) of at least one valve cabinet (24, 26) in each case are electrically connected-conductively to one phase level (P1, P2, P3) of the inductor cabinet (48), which are arranged next to one another.

2. Modular converter cabinet system according to claim 1,
**characterised in that** the first valve cabinet (24) has two honeycomb cells (46) per valve level (V1,...,V6).

3. Modular converter cabinet system according to claim 1,
**characterised in that** the second valve cabinet (26) has four honeycomb cells (46) per valve level (V1,...,V6).

4. Modular converter cabinet system according to claim 1,
**characterised in that** the converter cells (2) of an upper and lower valve branch (T1, T2; T3, T4; T5, T6) of a respective phase module (1, 3, 5) are arranged in honeycomb cells (46) of neighbouring valve levels (V1, V2; V3, V4; V5, V6) of a valve cabinet (24, 26).

5. Modular converter cabinet system according to claim 1,
**characterised in that** the converter cells (2) of a respective upper converter valve (T1, T3, T5) of the phase modules (1, 3, 5) of the converter and the converter cells (2) of a respective lower converter valve (T2, T4, T6) of the phase modules (1, 3, 5) of the converter are each arranged in neighbouring valve levels (V1, V2, V3; V4, V5, V6) of a valve cabinet (24, 26).

6. Modular converter cabinet system according to claim 5,
**characterised in that** the converter cells (2) of the upper converter valves (T1, T3, T5) are arranged in the upper valve levels (V1, V2, V3) of a valve cabinet (24, 26), wherein the sequence corresponds to the sequence of the phase modules (1,3,5) of the converter.

7. Modular converter cabinet system according to claim 5,
**characterised in that** the converter cells (2) of the lower converter valves (T2, T4, T6) are arranged in the upper valve levels (V1, V2, V3) of a valve cabinet (24, 26), wherein the sequence of the lower and upper converter valves (T2, T4, T6; T1 T3, T5) of the phase modules (1,3,5) in upper and lower valve levels (V1, V2, V3; V4, V5, V6) of the valve cabinet (24, 26) is selected such that a lower and an upper converter valve (T4, T3) of a phase module (1, 3, 5) are arranged in neighbouring valve levels (V3, V4).

8. Modular converter cabinet system according to claim 1 and 2,
**characterised in that** the first valve cabinet (24) and the inductor cabinet (48) are connected electrically-conductively to one another.

9. Modular converter cabinet system according to claim 1 and 3,
**characterised in that** the second valve cabinet (26) and the inductor cabinet (48) are connected electrically-conductively to one another.

10. Modular converter cabinet system according to claim 1, 2 and 3,
**characterised in that** the first valve cabinet (24), the second valve cabinet (26) and the inductor cabinet (48) are connected electrically-conductively to one another.

11. Modular converter cabinet system according to claim 1 and 3,
**characterised in that** two second valve cabinets (26) and the inductor cabinet (48) are connected electrically-conductively to one another.

12. Modular converter cabinet system according to claim 1, 2 and 3,
**characterised in that** a first valve cabinet (24), two second valve cabinets (26) and the inductor cabinet (48) are connected electrically-conductively to one another.

13. Modular converter cabinet system according to claim 1 and 3,
**characterised in that** three second valve cabinets (26) and the inductor cabinet (48) are connected electrically-conductively to one another.

14. Modular converter cabinet system according to claim 13,
**characterised in that** the valve levels (V1,...,V6) of a valve cabinet (24, 26) are arranged between two side walls (28, 30; 32, 34) spaced apart above one another.

15. Modular converter cabinet system according to claim 14,
**characterised in that** the two side walls (28, 30; 32, 34) are spaced apart by means of two spacer bars (36, 38) above the upper valve level (V1) and two spacer bars (36, 38) below the lower valve levels (V6).

16. Modular converter cabinet system according to claim 14,
**characterised in that** each side wall (28, 30; 32, 34) has a cutout (40) for each valve level (V1,...,V6) on its front side.

17. Modular converter cabinet system according to claim 16,
**characterised in that** cross bars (44) are arranged in each case in the cutouts (40) of two sidewalls (28, 30; 32, 34) kept at a distance from one another.

18. Modular converter cabinet system according to one of claims 14 to 17, **characterised in that** the support structure (20, 22) consisting of side walls (28, 30; 32, 34), spacer bars (36, 38) and cross bars (44) consists of a plurality of converter cells (2) of a valve cabinet (24, 26) made of the electrically-insulating material.

19. Modular converter cabinet system according to claim 1,
**characterised in that** a two-pulse subsystem (4) is provided as a converter cell (2), having two disconnectable semiconductors (T₁₁, T₁₂) connected in series each with a diode (D₁₁, D₁₂) connected antiparallel and a storage capacitor (C_{SM}) , wherein this storage capacitor series circuit is electrically connected to this series circuit.

20. Modular converter cabinet system according to claim 1,
**characterised in that** a double submodule (6) is provided as the converter cell (2), having four disconnectable semiconductors (T₁₁, T₁₂, T₂₁, T₂₂) electrically connected in series, each with a diode (D₁₁, D₁₂, D₂₁, D₂₂) connected antiparallel and two storage capacitors (C_{SM}), wherein these two storage capacitors (C_{SM}) are connected on one side electrically in series and on the other side in each case a series circuit of two disconnectable semiconductors (T₁₁, T₁₂; T₂₁, T₂₂) is connected electrically in parallel.

## Revendications

1. Système d'armoire de convertisseur de puissance modulaire d'un convertisseur, comprenant au moins un module ( 1, 3, 5 ) de phase ayant une valve ( T1,..., T6 ) de convertisseur supérieure et une valve ( T1,..., T6 ) de convertisseur inférieure, **caractérisé en ce que** chacune des valves ( T1,..., T6 ) de convertisseur a au moins deux cellules de redresseur et une self ( L_{T1},..., L_{T6} ) de dérivation, qui sont montés électriquement en série comprenant une première armoire ( 24 ) de valve, une deuxième armoire ( 26 ) de valve et une armoire ( 48 ) de self, les armoires ( 24, 26 ) de valve comportant plusieurs étages ( V1, ..., V6 ) à distance les uns au-dessus des autres et ayant plusieurs cellules ( 46 ) en nid d'abeille montées les unes à côté des autres, l'armoire ( 48 ) ayant plusieurs étages ( P1, P2, P3 ) de phase à distance les uns au-dessus des autres et dans lequel respectivement deux étages ( V1, V2, V3, V4, V5, V6 ) de valve d'au moins une armoire ( 24, 26 ) de valve sont reliés d'une manière conductrice de l'électricité respectivement avec un étage ( P1, P2, P3 ) de phase de l'armoire ( 48 ) de self, qui sont disposés les uns à côté des autres.

2. Système d'armoire de convertisseur modulaire suivant la revendication 1,
**caractérisé en ce que** la première armoire ( 24 ) de valve a deux cellules ( 46 ) en nid d' abeille par étage ( V1, ..., V6 ) de valve.

3. Système d'armoire de convertisseur modulaire suivant la revendication 1,
**caractérisé en ce que** la deuxième armoire ( 26 ) de valve a quatre cellules ( 46 ) en nid d'abeille par étage ( V1, ..., V6 ) de valve.

4. Système d'armoire de convertisseur modulaire suivant la revendication 1,
**caractérisé en ce que** les cellules de redresseur d'une dérivation ( T1, T2, T3, T4, T5, T6 ) de valve supérieure et inférieure respectivement d'un module ( 1, 3, 5 ) de phase sont disposées dans des cellules ( 46 ) en nid d'abeille d'étages ( V1, V2, V3, V4, V5, V6 ) de valve voisins d'une armoire ( 24, 26 ) de valve.

5. Système d'armoire de convertisseur modulaire suivant la revendication 1,
**caractérisé en ce que** les cellules ( 2 ) de redresseur respectivement d'une valve ( T1, T3, T5 ) de redresseur supérieure des modules ( 1, 3, 5 ) de phase du redresseur et les cellules ( 2 ) de redresseur respectivement d'une valve ( T2, T4, T6 ) de redresseur inférieure des modules ( 1, 3, 5 ) de phase du redresseur sont disposées respectivement dans les étages ( V1, V2, V3, V4, V5, V6 ) de valve voisins d'une armoire ( 24, 26 ) de valves.

6. Système d'armoire de convertisseur modulaire suivant la revendication 5,
**caractérisé en ce que** les cellules ( 2 ) de redresseur des valves ( T1, T3, T5 ) de redresseur supérieures sont disposées dans les étages ( V1, V2, V3 ) de valve supérieurs d'une armoise ( 24, 26 ) de valve, la succession correspondant à la succession des modules ( 1, 3, 5 ) de phase du redresseur.

7. Système d'armoire de convertisseur modulaire suivant la revendication 5,
**caractérisé en ce que** les cellules ( 2 ) du redresseur des valves ( T2, T4, T6 ) de redresseur inférieures sont disposées dans les étages ( V1, V2, V3 ) de valve supérieurs d'une armoire ( 24, 26 ) de valve, la succession des valves ( T2, T4, T6 ; T1, T3, T5 ) inférieures et supérieures des modules ( 1, 3, 5 ) de phase dans les étages ( V1, V2, V3, V4, V5, V6 ) de valve supérieurs et inférieurs de l'armoire ( 24, 26 ) de valve étant choisie de manière à disposer une valve ( T4 ) de redresseur inférieure et une valve ( T3 ) de redresseur supérieure d'un module ( 1, 3, 5 ) de phase dans des étages ( V3, V4 ) de valve voisins.

8. Système d'armoire de convertisseur modulaire suivant les revendications 1 et 2,
**caractérisé en ce que** la première armoire ( 24 ) de valve et l'armoire ( 48 ) de self sont reliées entre elles d'une manière conductrice de l'électricité.

9. Système d'armoires de convertisseur modulaire suivant les revendications 1 et 3,
**caractérisé en ce que** la deuxième armoire ( 26 ) de valve et l'armoire ( 48 ) de self sont reliées entre elles d'une manière conductrice de l'électricité.

10. Système d'armoire de convertisseur modulaire suivant les revendications 1, 2 et 3,
**caractérisé en ce que** la première armoire ( 24 ) de valve, la deuxième armoire ( 26 ) de valve et l'armoire ( 46 ) de self sont reliées entre elles d'une manière conductrice de l'électricité.

11. Système d'armoire de convertisseur modulaire suivant les revendications 1 et 3,
**caractérisé en ce que** deux deuxièmes armoires ( 26 ) de valve et l'armoire ( 48 ) de self sont reliées entre elles d'une manière conductrice de l'électricité.

12. Système d'armoire de convertisseur modulaire suivant les revendication 1, 2 et 3,
**caractérisé en ce qu'**une première armoire ( 24 ) de valve, deux deuxièmes armoire ( 26 ) de valve et l'armoire ( 48 ) de self sont reliées entre elles d'une manière conductrice de l'électricité.

13. Système d'armoire de convertisseur modulaire suivant les revendications 1 et 3,
**caractérisé en ce que** trois deuxièmes armoires ( 26 ) de valve et l'armoire ( 48 ) de self sont reliées entre elles d'une manière conductrice de l'électricité.

14. Système d'armoire de convertisseur modulaire suivant la revendication 13,
**caractérisé en ce que** les étages ( V1, ..., V6 ) de valve d'une armoire ( 24, 26 ) de valve sont disposés en étant à distance les uns au-dessus des autres entre deux parois ( 28, 30 ; 32, 34 ) latérales.

15. Système d'armoire de convertisseur modulaire suivant la revendication 14,
**caractérisé en ce que** les deux parois ( 28, 30 ; 32, 34 ) latérales sont mises à distance au moyen de deux entretoises ( 36, 38 ) au-dessus de l'étage ( V1 ) de valve supérieur et deux entretoises ( 36, 38 ) en-dessous de l'étage ( V6 ) de valve inférieur.

16. Système d'armoire de convertisseur modulaire suivant la revendication 14,
**caractérisé en ce que** chaque paroi ( 28, 30 ; 32, 34 ) latérale a, du côté avant, pour chaque étage ( V1, ..., V6 ) de valve un évidement ( 40 ).

17. Système d'armoire de convertisseur modulaire suivant la revendication 1,
**caractérisé en ce que** des traverses ( 44 ) sont disposées respectivement dans les évidements ( 40 ) de deux parois ( 28, 30 ; 32, 34 ) latérales maintenues à distance.

18. Système d'armoire de convertisseur modulaire suivant l'une des revendications 14 à 17,
**caractérisé en ce que** la construction ( 20, 22 ) porteuse formée des parois ( 28, 30; 32, 34 ) latérales, des entretoises ( 36, 38 ) et des traverses ( 44 ) est constituée d'une pluralité de cellules ( 2 ) de redresseur d'une armoire ( 24, 26 ) de valve en matériau isolant du point de vue électrique.

19. Système d'armoire de convertisseur modulaire suivant la revendication 1,
**caractérisé en ce qu'**il est prévu comme cellule ( 2 ) de redresseur un sous-système ( 4 ) bipolaire, qui a deux semi-conducteurs ( T₁₁, T₁₂ ) montés en série électriquement et pouvant être mis hors circuit, ayant respectivement une diode ( D₁₁, D₁₂ ) montée tête bêche et un condensateur (C_{SM}) de stockage, dans lequel le condensateur de ce circuit série est connecté électriquement à ce circuit série.

20. Système d'armoire de convertisseur modulaire suivant la revendication 1,
**caractérisé en ce qu'**il est prévu comme cellule ( 2 ) de redresseur un sous-module ( 6 ) double, qui a quatre semi-conducteurs ( D₁₁ D₁₂, D₂₁, D₂₂ ) montés électriquement en série et pouvant être mis hors circuit, ayant respectivement une diode ( D₁₁, D₁₂, D₂₁, D₂₂ ) montée tête bêche et deux condensateurs ( C_{SM} ) de stockage, ces deux condensateurs ( C_{SM} ) de stockage étant connectés d'une part électriquement en série et d'autre part respectivement un circuit série de deux semi-conducteurs ( T₁₁, T₁₂, T₂₁, T₂₁ ) pouvant être mis hors circuit étant montés en parallèle.
